# EUROPEAN PATENT SPECIFICATION

(11) **EP 0 485 176 B1**
(45) Date of publication and mention of the grant of the patent: **04.09.1996**
(21) Application number: 91310229.9
(22) Date of filing: 05.11.1991
(51) Int. Cl.: H05K 3/20, H01G 4/30

(54) **Metal thin film having excellent transferability and method of preparing the same**
Dünne Metallschicht mit ausgezeichneter Übertragungsfähigkeit und Verfahren zu ihrer Herstellung
Film mince en métal possédant d'excellentes qualités de transfert et son procédé de fabrication

(30) Priority: 05.11.1990 JP 300347/90; 17.06.1991 JP 144591/91
(43) Date of publication of application: 13.05.1992
(73) Proprietor: MURATA MANUFACTURING CO., LTD., Nagaokakyo-shi, Kyoto 617 (JP)
(72) Inventor: Hosokawa, Takao, c/o Murata Manufacturing Co., Ltd, Nagaokakyo-shi, Kyoto (JP); Kohno, Yoshiaki, c/o Murata Manufacturing Co., Ltd, Nagaokakyo-shi, Kyoto (JP)
(74) Representative: Milhench, Howard Leslie

(56) References cited:
- EP-A- 0 381 879
- GB-A- 2 082 632
- US-A- 4 568 413

## Description

### BACKGROUND OF THE INVENTION

The invention relates to a method of manufacturing a ceramic electronic component from a plurality of ceramic green sheets. In the practice of the invention a metal thin film is transferred from a carrier to ceramic green sheets during the manufacture of the component.

Japanese Patent Laying-Open No. 1-42809 (1989) discloses a transfer technique which is employed for forming electrodes for an electronic component, more specifically, internal electrodes for a multilayer ceramic capacitor, for example. Such a transfer technique is evaluated as a technique which is effective for forming thin internal electrodes.

In more detail, a thin-film-forming method such as vapour deposition or sputtering is known as a method of forming thin internal electrodes, i.e., metal thin films. While a plurality of unfired ceramic green sheets are laminated in order to prepare a multilayer ceramic capacitor, internal electrodes, which are provided between adjacent ones of the ceramic green sheets, must be formed in advance of lamination. However, it is difficult to directly form metal thin films on the ceramic green sheets, which are mechanically weak and hard to handle, by the aforementioned thin-film-forming method. In the first place, therefore, thin films for defining internal electrodes are formed on handleable films which are different from ceramic green sheets, and then transferred onto ceramic green sheets, so that it is easy or possible to form the metal thin films on the ceramic green sheets.

Thus, the internal electrodes are formed by metal thin films through a transfer technique, so that it is possible to reduce the dimensions, particularly the thickness, of the as-formed multilayer ceramic capacitor. In addition, it is also possible to further homogenize the thickness in the laminated state along the direction of extension of the ceramic green sheets. Due to the latter property, it is possible to reduce a possibility of inconvenience such as delamination after firing of the laminated ceramic green sheets.

While the transfer technique enables formation of internal electrodes of metal thin films which provide some advantages in relation to a multilayer ceramic capacitor, it is desirable that each metal thin film is completely transferred onto a target surface with excellent transferability, in order to carry out the transfer technique. If the metal thin film is not completely transferred with a desired pattern by the transfer technique which is employed for forming an internal electrode for a multilayer ceramic capacitor, for example, the as-formed multilayer ceramic capacitor is rendered defective, as a matter of course.

US-A-4,568,413 was cited by the European Patent Office during examination. The US specification is concerned with metallised and plated laminates, and describes a structure which includes a carrier layer, a vacuum vapour metallised layer weakly attached to the carrier layer and an electroplated layer integrally bonded to the vacuum metallised layer.

EP-A-381,879 was also cited by the European Patent Office during examination. The European specification is concerned with a method of manufacturing a laminated ceramic electronic component. The specification describes the forming of a metal thin film on a backing film by vapour deposition or sputtering and the transfer of selected portions of the metal film from the backing film to a ceramic green sheet by the application of pressure at the selected portions. Plural green sheets having patterned metal film thereon are then stacked to form the electronic component.

### SUMMARY OF THE INVENTION

According to the invention there is provided a method of manufacturing a ceramic electronic component as set forth in claim 1.

Metals for forming the first and second metal layers may be different from or identical to each other.

The first metal layer may be formed of nickel, copper or silver, for example. The second metal layer may be formed of nickel, copper or palladium, for example.

The film employed for forming the metal layers should have flexibility and heat resistance, as well as sufficient resistance against vapour deposition, wet plating and patterning with photolithography or the like. Such a film is prepared from a resin film of polyethylene terephthalate etc., or a metallic foil of nickel, copper aluminium or the like.

The metal layers together are prepared with excellent transferability, to be transferred onto a target of a ceramic green sheet. As to transfer conditions, in the practice of the invention the metal layers are first brought into contact with the target, and then transferred thereto under a pressure of 10 to 500 kg/cm² at a temperature of 60 to 95°C, for example by so-called hot stamping.

The transferability results from the fact that a metal thin film which is formed on a carrier film by vapour deposition generally has relatively weak adhesion with respect to the carrier film, i.e., it has excellent transferability.

However, easiness of vapour deposition for forming a metal thin film depends on the type of metal used. Further, transferability of a metal thin film which is formed by vapour deposition also depends on the type of metal used. Therefore, it is necessary to prepare the material for the thin film, which is formed on a carrier film by vapour deposition, from a metal which is excellent in transferability and easy to deposit. However, a metal selected in consideration of easiness in vapour deposition and transferability is not necessarily suitable as an electrode material for a target electronic component or the like. When a metal layer is formed only by vapour deposition along its overall thickness, further, a peel surface of the film is thermally denatured in the vapour deposition process, to require high peel strength or cause difficulty in peeling. Further, the film is warped by residual stress of the metal layer which is obtained by vapour deposition. In addition, a long time is required for forming the metal layer due to a low vapour deposition rate, leading to increase in manufacturing cost.

Therefore, the first metal layer is formed of a metal which is selected in consideration of easiness in vapour deposition and transferability, while the second metal layer is formed above the first metal layer to compensate for properties which are insufficient in the metal forming the first metal layer. The second metal layer can be formed of an optimum metal which is selected in consideration of properties required for an electrode for a target electronic component or the like, since it is not necessary to consider easiness in vapour deposition and transferability. Further, the second metal layer also compensates for the thickness of the first metal layer which is formed by vapour deposition in addition to compensating for insufficient properties of the first metal layer, to easily attain a thickness required for the overall metal thin film to be transferred. Therefore, the first and second metal layers may be formed of either different or identical metals.

Further, the second metal layer is formed by wet plating such as electroplating or electroless plating. When the second metal layer is formed above the first metal layer by wet plating, adhesion of the first metal layer with respect to the film is not increased as compared with a case of forming a metal layer only by vapour deposition along its overall thickness.

Thus, the metal thin film is provided with at least two layers including first and second metal layers, so that the first metal layer is adapted to provide transferability while the second metal layer is adapted to provide properties which are required for an electrode for a target electronic component or the like. Therefore, it is easy to satisfy both transferability and other desired properties over the entire metal thin film. For example, a metal thin film having excellent transferability can be formed by a metal, which has not been suitable for transfer in general, to widen the range of metals that can be subjected to transfer, while it is also possible to widen the range of application of the transferable metal thin film.

Since it is easy to pattern a metal thin film which is formed on a film by photoetching, for example, a metal thin film can be advantageously applied as an electrode for an electronic component, an internal or external conductor for a multilayer substrate, a conductor which is provided on a circuit board, a display metallic foil, or the like.

The foregoing features are set forth with particularity in the appended claims and together with other objects, aspects and advantages of the present invention will become more apparent from the following detailed description of an embodiment of the present invention when taken in conjunction with the accompanying drawings.

### BRIEF DESCRIPTION OF THE DRAWINGS

In the drawings:

Fig. 1 is a sectional view showing one carrier carrying metal layers which is used in the present invention; and

Fig. 2 is a sectional view showing another carrier carrying metal layers which is used in the present invention.

### DESCRIPTION OF AN EMBODIMENT OF THE INVENTION

In the following a number of experimental examples of the placing of metal layers onto a carrier will be described so that the method of the present invention can be seen in context.

### Experimental Example 1

Experimental Example 1 was adapted to prepare a transfer metallic foil.

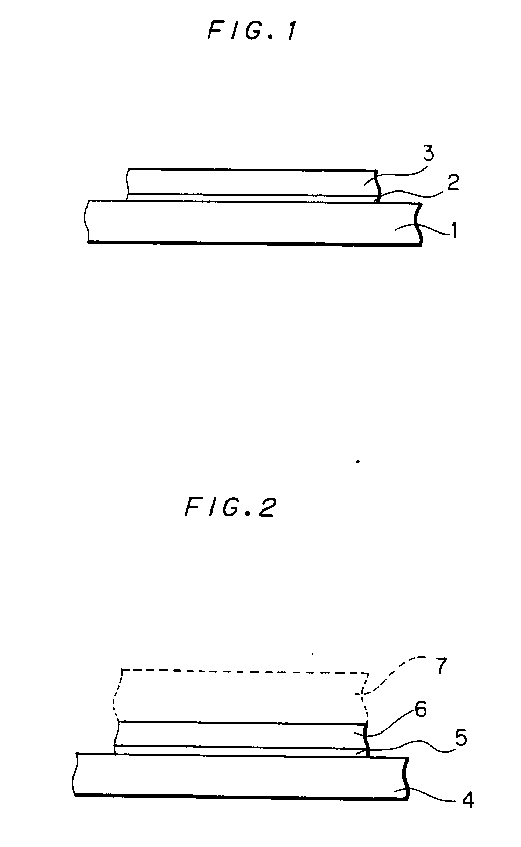

A film 1 was first prepared as shown in fig. 1. This film 1 was prepared from polyethyline terephthalate, which is not deformed even under a temperature of about 100°C, and coated with silicon in order to further improve the transferability of a metal thin film to be formed.

Then, a nickel deposition film 2 was formed on the film 1, as shown in Fig. 1. This nickel deposition film 2 was formed by electron beam heating with an acceleration voltage of 10 kV under an atmosphere pressure of not more than 5 x 10⁻⁴ Torr. The as-formed nickel deposition film 2 was 0.1 µm in thickness (comparative sample 1).

Then, a nickel plating film 3 was formed on another nickel deposition film 2 by electroplating, as shown in Fig. 1. The electroplating step was carried out with a current density of 1 A/dm² in a plating bath of sulfonamino acid, while setting the nickel deposition film 2 and a nickel plate on minus and plus sides respectively. Such plating was performed for 3 minutes, to obtain the nickel plating film 3 of 1 µm in thickness (inventive sample 1). (The term "inventive sample" is used herein to refer to carriers having metal films suitable for use in the invention and the term "comparative sample" is used to refer to carriers having metal films unsuitable for use in the invention.)

Then, a nickel plating film 3 was formed on still another nickel deposition film 2 by electroless plating, in place of the aforementioned electroplating, as shown in Fig. 1. The electroless plating step was carried out in an alkaline hydrazine bath at a liquid temperature of 80°C. Such plating was performed for 4 minutes, to obtain the nickel plating film 3 of 1 µm in thickness (inventive sample 2).

The aforementioned comparative sample 1 and the inventive samples 1 and 2 were subjected to evaluation of transferability onto paper and plastic surfaces. first, the surfaces of the metal thin films, i.e., those of the nickel deposition film 2 in the comparative sample 1 and the nickel plating films 3 in the inventive samples 1 and 2, were coated with adhesive agents. Then, the metal thin films were transferred to the paper and plastic surfaces by hot stamping, with application of a pressure of 100 kg/cm² for 10 seconds.

According to the comparative sample 1, the metal thin film, i.e., the nickel deposition film 2, was transferred onto the paper and plastic surfaces when the hot stamping temperature was 100°C. In the inventive samples 1 and 2, on the other hand, it was possible to transfer the metal thin films, i.e., the nickel deposition films 2 and the nickel plating films 3, onto the paper and plastic surfaces at a temperature of 80°C.

In the aforementioned Experimental Example 1, similar results were obtained also when gold, silver and copper were employed in place of nickel. Further, similar results were obtained also when at least two layers were prepared from such metals.

### Experimental Example 2

As shown in Fig. 2, a film 4 was first prepared from the same material as the film 1 employed in Experimental Example 1.

Then, a copper deposition film 5 of 0.1 µm in thickness was formed on the film 4 by vapour deposition under the same conditions as Experimental Example 1 (comparative sample 2).

Then, a nickel plating film 6 of 1 µm in thickness was formed on another copper deposition film 5 by electroplating under the same conditions as Experimental Example 1 (inventive sample 3).

In addition, a nickel plating film 6 of 1 µm in thickness was formed on still another copper deposition film 5 by electroless plating, in place of the aforementioned electroplating, under the same conditions as Experimental Example 1 (inventive sample 4).

In order to evaluate transferability of the comparative sample 2 and the inventive samples 3 and 4, the following experiment was performed:

A slurry was prepared from a nonreducing dielectric ceramic material which was mainly composed of barium titanate. The surfaces of the metal films, i.e., those of the copper deposition film 5 in the comparative sample 2 and the nickel plating films 6 in the inventive samples 3 and 4, were coated with this slurry and dried to form ceramic green sheets 7, which were then peeled. In the comparative sample 2, the copper deposition film 5 was not in the least separated from the film 4, although the ceramic green sheet 7 was peeled. In the inventive samples 3 and 4, on the other hand, the copper deposition films 5 and the nickel plating films 6 were separated from the films 4 upon peeling of the ceramic green sheets 7.

### Experimental Example 3

A film 1 was prepared in a similar manner to Experimental Example 1.

Then, a copper deposition film 2 of 1 µm in thickness was formed on the film 1 by vapour deposition as shown in Fig. 1, under the same conditions as Experimental Example 1 (comparative sample 3).

Also, a copper deposition film 2 of 0.1 µm in thickness was formed on another film 1 by vapour deposition as shown in Fig. 1, and a copper plating film 3 of 1 µm in thickness was formed on the copper deposition film 2 by electroplating under the same conditions as Experimental Example 1 (inventive sample 5).

Then, a copper plating film 3 of 1 µm in thickness was formed on still another copper deposition film 2 by electroless plating in place of the aforementioned electroplating, under the same conditions as Experimental Example 1 (inventive sample 6).

In order to evaluate transferability of the comparative sample 3 and the inventive samples 5 and 6, the following experiment was performed:

A pair of 2 cm-square plates were prepared to hold each of the comparative sample 3 and the inventive samples 5 and 6, and contact surfaces therebetween were fixed to each other with an adhesive agent. In this case, the plates were outwardly pulled to examine strength required for peeling the copper deposition film 2 from the film 1. The comparative sample 3 required peel strength of 3000 g, while the inventive samples 5 and 6 required 2000 g respectively.

Further, it was difficult to pattern the comparative sample 3 by photoetching, since the film 1 was extremely warped and it was difficult to obtain a flat surface.

### Experimental Example 4

A film 1 was prepared in a similar manner to Experimental Example 1.

Then, a nickel deposition film 2 of 1 µm in thickness was formed on the film 1 by vapour deposition as shown in Fig. 1, under the same conditions as Experimental Example 1 (comparative sample 4).

Also, a nickel deposition film 2 of 0.1 µm in thickness was formed on another film 1 by vapour deposition as shown in Fig. 1, and a nickel plating film of 1 µm in thickness was formed on the nickel deposition film 2 by electroplating under the same conditions as Experimental Example 1 (inventive sample 7).

Then, a nickel plating film 3 of 1 µm in thickness was formed on still another nickel deposition film 2 by electroless plating, in place of the aforementioned electroplating, under the same conditions as Experimental Example 1 (inventive sample 8).

The comparative sample 4 and the inventive samples 7 and 8 were subjected to evaluation of transferability similarly to Experimental Example 1. In the comparative sample 4, it was impossible to transfer the metal thin film even if hot stamping was performed at a temperature of 100°C. Further, it was difficult to pattern the comparative sample 4 by photoetching since the nickel deposition film 2 was extremely cracked and the film 1 was so warped that it was difficult to obtain a flat surface. In the inventive samples 7 and 8, on the other hand, it was possible to transfer the metal thin films, i.e., the nickel deposition films 2 and the nickel plating films 3, onto paper and plastic surfaces at a temperature of 80°C.

### Method Embodying the Invention

A multilayer capacitor was formed in the following manner. First, inventive samples 3 and 4 were prepared according to the method described herein above under the heading "Experimental Example 2".

Then, the nickel plating films 6 of the inventive samples 3 and 4 were coated with photoresist films, and thereafter the metal thin films, i.e., the copper deposition films 5 and the nickel plating films 6, were patterned to form internal electrodes for multilayer ceramic capacitors by photoetching.

Then, ceramic green sheets 7 of 10 to 15 µm in thickness were formed on the surfaces of the films 4, which were provided with the metal thin films, by a doctor blade coater. The ceramic green sheets 7 were formed of the aforementioned slurry of a nonreducing dielectric ceramic material.

Then, a plurality of such ceramic green sheets 7 were stacked with thermocompression bonding applied to every green sheet as it is added to the stack, and the films 4 were peeled after every thermocompression bonding. In this case, the metal thin films were completely separated from the films 4.

Each of the as-formed laminates were cut in dimensions for defining a single multilayer ceramic capacitor, fired and provided with external electrodes, thereby forming a multilayer ceramic capacitor.

The as-formed multilayer ceramic capacitor was smaller in thickness as compared with a conventional typical multilayer ceramic capacitor whose internal electrodes were formed by screen printing of metal paste, and its thickness was further homogeneous along the direction of extension of the ceramic sheets. In addition, no deterioration of electric characteristics, such as reduction of capacitance, was observed since the internal electrodes exhibited no defects such as pores.

While the present invention has been described in relation to Experimental Examples 1 to 4, the first and second metal layers may be prepared from arbitrary metals.

The second metal layer may not necessarily be brought into contact with the first metal layer. For example, at least a single third metal layer may be provided between the first and second metal layers. In this case, the third metal layer may be formed by a method such as sputtering, electroplating, electroless plating or the like.

The film for forming the first metal layer, which is prepared from resin, for example, may not inevitably be subjected to treatment for improving transferability, such as the aforementioned silicon coating. When the film itself is formed of a material which essentially has small adhesion with respect to a metal, it is not necessary to perform surface treatment for improving transferability.

In addition to the aforementioned Examples, it is possible to form the following substance by properly selecting materials for the first and second metal layers:

A first metal layer which is prepared from copper and a second metal layer which is prepared from nickel are transferred onto a ceramic green sheet for a semiconducting ceramic capacitor. A plurality of such ceramic green sheets are laminated and then fired so that the same are vitrified. Thereafter re-oxidation treatment is performed to diffuse copper into the ceramic material and convert grain boundaries of the semiconducting ceramic material into insulator states, thereby obtaining an intergranularinsulated multilayer ceramic capacitor.

Alternatively, a first metal layer of aluminium second metal layer of copper and a third metal layer of aluminium may be transferred onto a ceramic green sheet. A plurality of such ceramic green sheets are laminated and then fired, so that the aluminium layers are converted to Al₂O₃ layers, thereby preventing diffusion of copper. Such a technique is so applied to preparation of a multilayer ceramic capacitor as to prevent the ceramic layers from diffusion of co,per for forming internal electrodes. Thus, it is possible to prepare a multilayer ceramic capacitor which has small dispersion of characteristics, particularly capacitance. In this case, the second metal layer may be formed of nickel in place of copper, to attain a similar effect.

The present invention is advantageously applicable to forming electrodes for an electronic component, more specifically, internal electrodes for a multilayer ceramic capacitor. For example, first, a capacitor can be obtained by the steps of transferring metal thin films onto ceramic sheets, and stacking the ceramic sheets. Secondly, a capacitor can be obtained by the steps of transferring metal thin films onto a ceramic block of a plurality of stacked ceramic sheets, further stacking a ceramic sheet on the ceramic block, transferring metal thin films onto the ceramic sheet, and repeating the last two steps. Thirdly, a capacitor can be obtained by the steps of forming a metal thin film on a film, forming a ceramic sheet on the surface of the film, which is provided with the metal thin film, peeling the ceramic sheet together with the metal thin film from the film, and stacking such peeled ceramic sheets. Fourthly, a capacitor can be obtained by the steps of forming a metal thin film on a film, forming a first ceramic sheet on the surface of the film, which is provided with the metal thin film, stacking the first ceramic sheet on a second ceramic sheet, and peeling the film from the first ceramic sheet.

Although the present invention has been described and illustrated in detail, it is clearly understood that the same is by way of illustration and example only and is not to be taken by way of limitation, the scope of the present invention being limited only by the terms of the appended claims.

## Claims

1. A method of manufacturing a ceramic electronic component from a plurality of ceramic green sheets, the method comprising:
preparing each of said plurality of ceramic green sheets by forming a first metal layer on a carrier by vapour deposition,
forming a second metal layer on said first metal layer by wet plating,
patterning said metal layers, and
applying a ceramic slurry to said patterned metal layers thereby to form a ceramic green sheet including said patterned metal layers on said carrier;
forming a stack of ceramic green sheets by taking one of said plurality of ceramic green sheets and peeling said carrier therefrom so that said one green sheet serves as the first sheet in the stack and repeatedly laminating another one of said plurality of ceramic green sheets to the stack and peeling said carrier therefrom; and
firing said stack.

2. A method according to claim 1, further comprising preparing a film of polyethylene terephthalate coated with silicon as said carrier.

3. A method according to claim 1 or 2, wherein said wet plating comprises electroplating.

4. A method according to claim 1 or 2, wherein said wet plating comprises electroless plating.

5. A method according to any preceding claim, wherein said first and second metal layers are formed of different metals.

6. A method according to any of claims 1 to 4, wherein said first and second metal layers are formed of the same type of metals.

7. A method according to any preceding claim, wherein said metal layers are patterned by photoetching.

8. A method according to any preceding claim, wherein the ceramic slurry is applied to said patterned metal layers by a doctor blade coater.

9. A method according to any preceding claim, wherein said ceramic green sheets are laminated by thermocompression bonding each sheet to said stack.

10. A method according to any preceding claim, further comprising forming a third metal layer between said first and second metal layers by sputtering, electroplating or electroless plating.

11. A method according to any preceding claim, further comprising re-oxidizing said first metal layer to diffuse the metal into the ceramic green sheet and convert grain boundaries of the ceramic green sheet into insulator states.

12. A method according to any preceding claim, further comprising applying external electrodes to said first stack so as to complete the ceramic electronic component.

13. A method according to claim 12, wherein said external electrodes are connected to said metal layers to form a multilayer ceramic capacitor.

## Patentansprüche

1. Verfahren zum Herstellen einer keramischen Elektronikkomponente aus mehreren ungebrannten Keramiklagen, bei dem jede der mehreren ungebrannten Keramiklagen durch folgendes hergestellt wird:
- Herstellen einer ersten Metallschicht auf einem Träger durch Dampfniederschlagung;
- Herstellen einer zweiten Metallschicht auf der ersten Metallschicht durch Naßplattierung;
- Mustern dieser Metallschichten und
- Auftragen einer Keramikaufschlämmung auf die gemusterten Metallschichten, um dadurch eine ungebrannte Keramiklage einschließlich der gemusterten Metallschichten auf dem Träger auszubilden;
- Herstellen eines Stapels ungebrannter Keramiklagen durch Festhalten einer der mehreren ungebrannten Keramiklagen und durch Abziehen des Trägers von dieser, damit diese eine ungebrannte Lage als erste Lage im Stapel dient, und wiederholtes Auflaminieren einer anderen der mehreren ungebrannten Keramiklagen auf den Stapel und Abziehen des Trägers davon; und
- Brennen des Stapels.

2. Verfahren nach Anspruch 1, ferner umfassend das Herstellen eines mit Silicon beschichteten Films aus Polyethylenterephthalat als Träger.

3. Verfahren nach einem der Ansprüche 1 oder 2, bei dem der Naßplattiervorgang Elektroplattieren umfaßt.

4. Verfahren nach einem der Ansprüche 1 oder 2, bei der Naßplattiervorgang stromloses Plattieren umfaßt.

5. Verfahren nach einem der vorstehenden Ansprüche, bei dem die erste und zweite Metallschicht aus verschiedenen Metallen hergestellt werden.

6. Verfahren nach einem der Ansprüche 1 bis 4, bei dem die erste und die zweite Metallschicht aus demselben Metalltyp hergestellt werden.

7. Verfahren nach einem der vorstehenden Ansprüche, bei dem die Metallschichten durch Photoätzen gemustert werden.

8. Verfahren nach einem der vorstehenden Ansprüche, bei dem die Keramikaufschlämmung durch eine Beschichtungseinrichtung mit Rakel auf die gemusterten Metallschichten aufgetragen wird.

9. Verfahren nach einem der vorstehenden Ansprüche, bei dem die ungebrannten Keramiklagen dadurch aufeinanderlaminiert werden, daß jede Lage durch Thermokompression mit dem Stapel verbunden wird.

10. Verfahren nach einem der vorstehenden Ansprüche, ferner umfassend das Herstellen einer dritten Metallschicht zwischen der ersten und zweiten Metallschicht durch Sputtern, Elektroplattieren oder stromloses Plattieren.

11. Verfahren nach einem der vorstehenden Ansprüche, ferner umfassend ein Wiederoxidieren der ersten Metallschicht, um das Metall in die ungebrannte Keramiklage einzudiffundieren und Korngrenzen der ungebrannten Keramiklage in Isolatorzustände umzuwandeln.

12. Verfahren nach einem der vorstehenden Ansprüche, ferner umfassend das Aufbringen von Außenelektroden auf den ersten Stapel, um die keramische Elektronikkomponente fertigzustellen.

13. Verfahren nach Anspruch 12, bei dem die Außenelektroden mit den Metallschichten verbunden werden, um einen mehrschichtigen Keramikkondensator herzustellen.

## Revendications

1. Procédé de fabrication d'un composant électronique en céramique à partir de plusieurs feuilles en céramique à l'état vert, le procédé comprenant les étapes consistant à:
préparer chacune desdites plusieurs feuilles en céramique à l'état vert en formant une première couche en métal sur un support, par dépôt de vapeur,
former une deuxième couche en métal sur ladite première couche en métal, par placage par voie humide,
former un motif à partir desdites couches en métal, et
appliquer une bouillie de céramique sur lesdites couches en métal dotées d'un motif, pour former de la sorte une feuille en céramique à l'état vert comprenant lesdites couches en métal dotées d'un motif sur ledit support;
former un empilement de feuilles en céramique à l'état vert en prenant une desdites plusieurs feuilles en céramique à l'état vert et en en séparant ledit support par pelage, de sorte que ladite feuille à l'état vert sert de première feuille de l'empilement, et en disposant en couches de manière répétée une autre desdites plusieurs feuilles en céramique à l'état vert sur l'empilement et en en séparant ledit support par pelage; et
cuire ledit empilement.

2. Procédé selon la revendication 1, comprenant en outre la préparation, en tant que ledit support, d'un film de polyéthylène téréphtalate revêtu de silicium.

3. Procédé selon la revendication 1 ou 2, dans lequel ledit placage par voie humide comprend l'électroplacage.

4. Procédé selon la revendication 1 ou 2, dans lequel ledit placage par voie humide comprend le placage par voie chimique.

5. Procédé selon l'une quelconque des revendications précédentes, dans lequel ladite première et ladite deuxième couches en métal sont formées de métaux différents.

6. Procédé selon l'une quelconque des revendications 1 à 4, dans lequel ladite première et ladite deuxième couches en métal sont formées du même type de métaux.

7. Procédé selon l'une quelconque des revendications précédentes, dans lequel un motif est formé à partir desdites couches en métal par photogravure.

8. Procédé selon l'une quelconque des revendications précédentes, dans lequel la bouillie de céramique est appliquée sur lesdites couches en métal dotées d'un motif par un applicateur à lame de raclage.

9. Procédé selon l'une quelconque des revendications précédentes, dans lequel lesdites feuilles en céramique à l'état vert sont disposées en couches par liaison par thermocompression de chaque feuille audit empilement.

10. Procédé selon l'une quelconque des revendications précédentes, comprenant en outre l'état consistant à former une troisième couche en métal entre ladite première et ladite deuxième couches en métal, par pulvérisation cathodique, par électroplacage ou par placage par voie chimique.

11. Procédé selon l'une quelconque des revendications précédentes, comprenant en outre l'étape consistant à réoxyder ladite première couche en métal pour faire diffuser le métal dans la feuille en céramique à l'état crue et rendre isolants les joints de grains de la feuille en céramique à l'état vert.

12. Procédé selon l'une quelconque des revendications précédentes, comprenant en outre l'étape consistant à appliquer des électrodes externes sur ledit premier empilement, de manière à terminer le composant électronique en céramique.

13. Procédé selon la revendication 12, dans lequel lesdites électrodes externes sont connectées auxdites couches en métal pour former un condensateur multicouche en céramique.
